Europäisches Patentamt

European Patent Office

Office européen des brevets

(11) Veröffentlichungsnummer: **0 229 411 B1**

## (12) EUROPÄISCHE PATENTSCHRIFT

(45) Veröffentlichungstag der Patentschrift: **13.05.92**

(21) Anmeldenummer: **86202141.7**

(22) Anmeldetag: **02.12.86**

(51) Int. Cl.⁵: **H05K 5/02**

(54) Anordnung zur Durchführung eines Kabels durch eine Gehäusewandöffnung.

(30) Priorität: **04.12.85 DE 3542871**

(43) Veröffentlichungstag der Anmeldung:
**22.07.87 Patentblatt 87/30**

(45) Bekanntmachung des Hinweises auf die
Patenterteilung:
**13.05.92 Patentblatt 92/20**

(84) Benannte Vertragsstaaten:
**DE FR GB IT SE**

(56) Entgegenhaltungen:
**DE-A- 2 916 448**
**FR-A- 2 407 590**
**US-A- 3 233 277**

(73) Patentinhaber: **Bauknecht Hausgeräte GmbH**
**Am Wallgraben 99**
**W-7000 Stuttgart 80(DE)**

(84) Benannte Vertragsstaaten:
**DE**

(73) Patentinhaber: **WHIRLPOOL INTERNATIONAL**
**B.V.**
**Luchthavenweg 34**
**NL-5507 SK Veldhoven(NL)**

(84) Benannte Vertragsstaaten:
**FR GB IT SE**

(72) Erfinder: **Schröder, Manfred**
**Im Füllengarten 67**
**W-6600 Saarbrücken 5(DE)**

(74) Vertreter: **Erdmann, Anton et al**
**Philips Patentverwaltung GmbH Wenden-**
**strasse 35 Postfach 105149**
**W-2000 Hamburg 1(DE)**

## Beschreibung

Die Erfindung bezieht sich auf eine Anordnung zur Durchführung eines Kabels durch eine Gehäusewandöffnung, die durch eine über ein Scharnier an der Gehäusewand befestigte Klappe verschließbar ist, wobei das Kabel zur Zugentlastung zwischen Gehäusewand und Klappe einklemmbar ist.

Aus der DE-OS 29 16 448 ist eine Kabeldurchführung eingangs erwähnter Art bekannt, bei der das Kabel zur Zugentlastung zwischen dem Mittelteil einer rechteckförmigen Klappe und dem Gehäuse einklemmbar ist. Das Mittelteil der Klappe ist relativ elastisch, so daß die sich hierbei ergebende Klemmhalterung für ein unter Zugspannung stehendes Netzanschlußkabel nicht fest genug ist, um eine sichere Zugentlastung des Kabels zu bewirken, so daß mit dem unter Zugspannung stehenden Kabel verbundene elektrische Bauelemente geschädigt werden können.

Aufgabe der Erfindung ist es, eine Kabeldurchführung eingangs genannter Art zu schaffen, die eine sichere Zugentlastung eines unter Zugspannung stehenden Kabels bewirkt.

Diese Aufgabe wird bei einer Kabeldurchführung eingangs definierter Art dadurch gelöst, daß an der Klappe einseitig offene, halbkreisförmige Scharnierösen angebracht sind, die in koaxial angeordnete und an einem Halter in der Gehäusewand befestigte Scharnierachsen einhängbar sind und daß die Scharnierösen mit Exzenternocken versehen sind, durch die ein bei geöffneter Klappe durch eine Öffnung im Halter durchgeführtes Kabel beim Schließen der Klappe zwischen dem Exzenter und einem Widerlager am Halter einklemmbar ist.

Bei einer vorteilhaften Ausgestaltung der Erfindung ist mindestens eine der beiden einander gegenüberliegenden Flächen des Exzenters und des Widerlagers gezahnt. Beim Schließen der Klappe klemmt die Zahnung den Isoliermantel des Kabels fest.

Ein Ausführungsbeispiel der Erfindung wird im folgenden anhand der Zeichnungen beschrieben. Es zeigen:

Fig. 1 eine Anordnung zur Durchführung eines Kabels mit einem rahmenförmigen Halter und einer daran befestigbaren Klappe.

Fig. 2 die Kabeldurchführung im Schnitt mit einem zwischen Exzenter und Widerlager eingeklemmten Kabel.

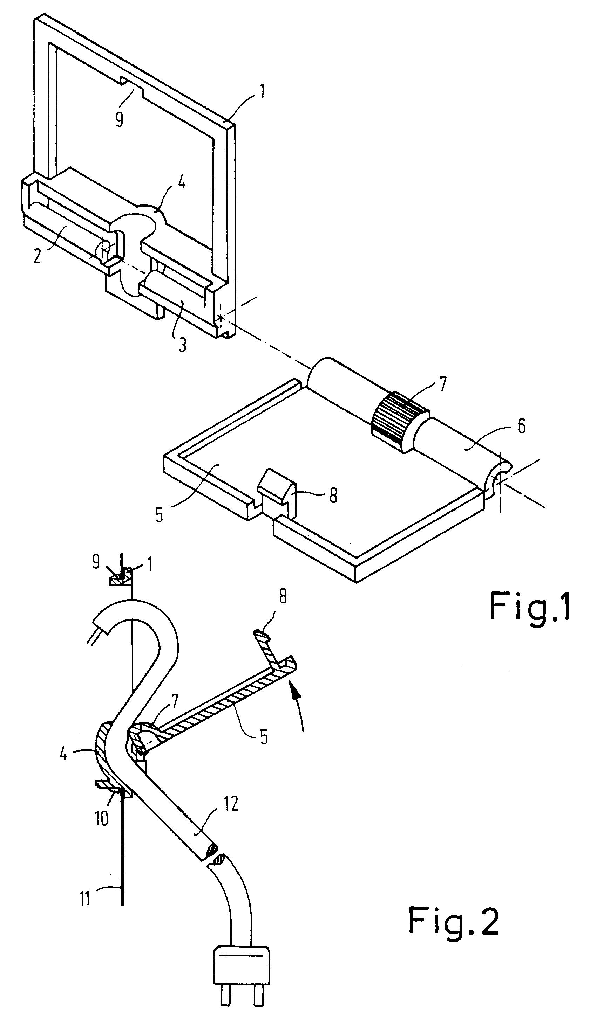

Die in Fig. 1 dargestellte Anordnung zur Durchführung eines Kabels weist einen rahmenförmigen Halter 1 auf, der in eine Gehäusewandöffnung eingesetzt ist. An der Unterseite des Halters 1 sind zwei koaxial angeordnete Scharnierachsen 2 und 3 angebracht, zwischen denen sich ein Zwischenraum befindet. Die Rückseite des Zwischenraumes ist als Widerlager 4 mit halbkreisförmigem Querschnitt ausgebildet.

Der rahmenförmige Halter 1 ist mit einer Klappe 5 verschließbar, an deren einer Seite eine nach unten offene Scharnieröse 6 angeformt ist. Der Mittelteil der Scharnieröse 6 ist als Exzenter 7 mit gezahnter Oberfläche ausgebildet. Weiterhin weist die Klappe 5 einen widerhakenförmigen Verschluß 8 auf, der beim Schließen der Klappe 5 in eine in den Halter 1 eingearbeitete Ausnehmung 9 einhakt.

Zum Schließen der Gehäusewandöffnung wird die Scharnieröse 6 der Klappe 5 in die Scharnierachsen 2 und 3 eingehängt.

Der in Fig. 2 dargestellte Schnitt ist derart durch die Anordnung zur Durchführung eines Kabels gelegt, daß der Halter 1, das Widerlager 4 und an der Klappe 5 der Exzenter 7 und der Verschluß 8 ersichtlich sind.

Zur Montage wird zunächst der Halter l mittels widerhakenförmiger Nasen 9 und 10 an der Gehäusewand 11 befestigt. Anschließend wird ein Kabel 12 durch eine Öffnung im Halter 1 zwischen den Scharnierachsen 2 und 3 hindurchgeführt. Schließlich wird die Klappe 5 über die Scharnierösen 6 in die Scharnierachsen 2 und 3 eingehängt und geschlossen. Hierbei wird das Kabel 12 zwischen Widerlager 4 und Exzenter 7 eingeklemmt. Die Zahnung des Exzenters 7 drückt die Isolierung des Kabels 12 ein, so daß sich nach Schließen der Klappe 5 eine feste und sichere Zugentlastung des Kabels 12 ergibt.

## Patentansprüche

1. Anordnung zur Durchführung eines Kabels (12) durch eine Gehäusewandöffnung, die durch eine über ein Scharnier an der Gehäusewand befestigte Klappe (5) verschließbar ist, wobei das Kabel (12) zur Zugentlastung zwischen Gehäusewand (11) und Klappe (5) einklemmbar ist, dadurch gekennzeichnet, daß an der Klappe (5) einseitig offene, halbkreisförmige Scharnierösen (6) angebracht sind, die in koaxial angeordnete und an einem Halter (1) in der Gehäusewand befestigte Scharnierachsen (2,3) einhängbar sind und daß die Scharnierösen (6) mit Exzenternocken (7) versehen sind, durch die ein bei geöffneter Klappe (5) durch eine Öffnung im Halter (1) durchgeführtes Kabel (12) beim Schließen der Klappe (5) zwischen dem Exzenter (7) und einem Widerlager (4) am Halter (1) einklemmbar ist.

2. Anordnung nach Anspruch 1, dadurch gekennzeichnet, daß mindestens eine der beiden einander gegenüberliegenden Flächen des Exzenters (7) und des Widerlagers (4) gezahnt ist.

**Claims**

1. A device for the passage of a cable (12) through an opening in the side of a housing, which opening can be closed with a lid (5) fastened to the housing wall by means of a hinge, whereby the cable (12) can be clamped in between the housing wall (11) and the lid (5) for strain relief, characterized in that semi-circular hinge sleeves (6) open at one side are provided at the lid (5), which sleeves (6) can close over coaxially arranged hinge pins (2,3) fastened at a support (1) in the housing wall, and in that the hinge sleeves (6) are provided with eccentric projections (7) by which a cable (12) after being passed through an opening in the support (1) while the lid (5) is open can be clamped in between the eccentric projection (7) and an abutment (4) at the support (1) when the lid (5) is closed.

2. A device as claimed in Claim 1, characterized in that at least one of the two opposing surfaces of the eccentric projection (7) and of the abutment (4) is toothed.

**Revendications**

1. Dispositif de traversée d'un câble (12) par une ouverture d'une paroi de carrosserie pouvant être fermée par un volet (5) fixé à la paroi de carrosserie par l'intermédiaire d'une charnière, le câble (12) pouvant être serré entre la paroi de carrosserie (11) et un volet (5) pour le soulagement de traction, caractérisé en ce que le volet (5) est muni d'oeillets de charnière semi-circulaires (6) ouverts d'un côté et pouvant être accrochés à des axes de charnière (2,3) disposés coaxialement et fixés sur un support (1) prévu dans la paroi de carrosserie, et en ce que les oeillets de charnière (6) sont munis d'ergots d'excentrique (7) permettant, lors de la fermeture du volet (5), de serrer entre l'excentrique (7) et une butée (4) du support (1) un câble (12) qui, à l'état ouvert du volet (5), passe par une ouverture du support (1).

2. Dispositif selon la revendication 1, caractérisé en ce qu'au moins l'une des deux surfaces opposées de l'excentrique (7) d'une part et de la butée (4) d'autre part est dentée.

Fig.1

Fig.2

4